# DEMANDE DE BREVET EUROPEEN

(11) **EP 4 679 955 A1**
(43) Date de publication de la demande: **14.01.2026**
(21) Numéro de dépôt: 25178857.6
(22) Date de dépôt: 26.05.2025
(51) Int. Cl.: H05K 7/20

(54) **DISPOSITIF DE CHARGE EMBARQUÉ ET MOYENS DE REFROIDISSEMENT D'UN MODULE DE PUISSANCE DE CE DISPOSITIF DE CHARGE EMBARQUÉ**

(30) Priorité: 09.07.2024 FR 2407474
(71) Demandeur: Valeo eAutomotive Germany GmbH, 91056 Erlangen (DE)
(72) Inventeur: ROUET, Amaury, 95892 Cergy Pontoise (FR); JORIS, Julien, 95892 Cergy Pontoise (FR); SUDARSANAN, Saneesh, 600130 Chennai, Tamil Nadu (IN); DURAIKANNU, Thiruvarutchelvan, 600130 Chennai, Tamil Nadu (IN); RANA, Gyana-Ranjan, 600130 Chennai, Tamil Nadu (IN); DUCA, Thomas, 95892 Cergy Pontoise (FR)
(74) Mandataire: Valeo Powertrain Systems

(57) **Abrégé**

Dispositif comprenant au moins un carter (2), des composants électroniques logés dans ledit carter et parmi lesquels au moins un module de puissance (20), le carter logeant en outre un dispositif de refroidissement de l'au moins un module de puissance, le dispositif de refroidissement comportant un réceptacle (6) qui comprend au moins un canal de liquide de refroidissement et une paroi de fermeture (8) configurée pour reposer contre le réceptacle (6) pour former avec ledit canal un circuit (10) de liquide de refroidissement, ledit module de puissance (20) étant rendu solidaire de la paroi de fermeture (8) dans une zone de positionnement (Z₁, Z₂, Z₃) du module de puissance, le dispositif de refroidissement étant caractérisé en ce que paroi de fermeture (8) comprend au moins une ouverture (18) aménagée dans ladite zone de positionnement et en ce que le dispositif de refroidissement comprend au moins un insert (30) configuré pour être disposé dans l'ouverture (18) et être interposé entre la paroi de fermeture et le module de puissance.

## Description

La présente invention se rapporte au domaine des chargeurs embarqués pour véhicule électrique.

Les chargeurs embarqués comprennent divers composants électroniques tel que des modules de puissance, des bobines ou des capacités, sans que cette liste soit exhaustive. Ces composants électroniques produisent de la chaleur lors de l'utilisation du chargeur embarqué.

Or, les véhicules électriques nécessitent des puissances de charge toujours plus élevées afin de réduire les temps de charge. L'augmentation de ces puissances de charge s'accompagne d'une production de chaleur de plus en plus importante lors du fonctionnement des chargeurs et impose de trouver des solutions pour réduire les contraintes thermiques sur les composants des chargeurs.

Plus particulièrement, les modules de puissance sont les composants électroniques qui produisent le plus de chaleur et il convient de les refroidir de manière efficace pour ne pas les endommager, alors que les modules de puissance peuvent présenter une température d'utilisation de 150°C.

Le module de puissance est de plus en plus utilisé dans les systèmes électroniques dans la mesure où il permet de compiler une pluralité de puces électroniques dans un espace réduit sur une carte de circuit imprimés. Plus précisément, le module de puissance comprend un boîtier au sein duquel sont disposées côte à côte des puces électroniques. Le boîtier comporte un socle permettant de supporter des puces électroniques et une paroi de recouvrement qui recouvre les puces et qui forme, en combinaison avec le socle, un volume interne dans lequel s'étend les puces. Les puces sont connectées à des broches de connexion électriques qui s'étendent à l'extérieur du module de puissance, notamment pour permettre le raccordement électrique des puces électroniques, logées à l'intérieur du boîtier, à un réseau électrique via une carte de circuits imprimés.

Le module de puissance présente une forme rectangulaire, définie par la forme rectangulaire du boîtier. En d'autres termes, le module de puissance comprend deux bords en opposition qui présentent chacune une dimension d'allongement plus importante que celle des deux autres bords. Les broches font saillie du boîtier sur l'un ou les deux bords présentant la dimension d'allongement la plus importante.

Il est connu de procéder au refroidissement d'un module de puissance en disposant ce module de puissance au contact d'une paroi d'un circuit de refroidissement au sein duquel circule un liquide de refroidissement. Le module de puissance est mis en contact avec cette paroi au niveau d'une paroi supérieure du boîtier du module de puissance, et les broches de connexion sont configurées pour pouvoir être raccordée sur une carte de circuits imprimés sans interférer avec la paroi du circuit de refroidissement.

Plus particulièrement, un dispositif de charge embarqué comprend un dispositif de refroidissement formé d'un réceptacle et d'une paroi de fermeture qui définissent entre eux un circuit de liquide de refroidissement, alimenté par un liquide de refroidissement qui a pour fonction de récupérer, à travers la paroi de fermeture, les calories du fonctionnement du module de puissance fixé sur la paroi de fermeture. La forme du circuit de liquide de refroidissement est définie par la forme d'un canal de circulation réalisé par des reliefs dans le réceptacle, cette forme étant destinée à faire passer sous chacun des modules de puissance le liquide de refroidissement. Il est connu de placer les modules de puissance le long du conduit de circulation, avec ces modules de puissance qui sont agencés parallèlement au sens de circulation du liquide dans la zone où le module de puissance considéré est fixé. En d'autres termes, les deux plus grands bords d'un module de puissance sont parallèles à la direction d'écoulement que présente le liquide de refroidissement dans la zone du module de puissance.

Cette solution de refroidissement est simple à mettre en œuvre mais peut être améliorée dans la mesure où les inventeurs ont pu constater que le refroidissement des puces électroniques au sein du boîtier du module de puissance pouvait ne pas être homogène d'une puce à l'autre, et pouvait ne pas être suffisant dans des cas de forte montée en température.

La présente invention s'inscrit dans ce contexte et vise à proposer un dispositif de charge embarqué dans lequel le module de puissance est refroidie de manière plus efficace.

La présente invention propose un dispositif de charge embarqué comprenant au moins un carter, des composants électroniques logés dans ledit carter et parmi lesquels au moins un module de puissance, le carter logeant en outre un dispositif de refroidissement de l'au moins un module de puissance, le dispositif de refroidissement comportant un réceptacle qui comprend au moins un canal de liquide de refroidissement et une paroi de fermeture configurée pour reposer contre le réceptacle pour former avec ledit canal un circuit de liquide de refroidissement, ledit module de puissance étant rendu solidaire de la paroi de fermeture dans une zone de positionnement du module de puissance, le dispositif de refroidissement étant caractérisé en ce que la paroi de fermeture comprend au moins une ouverture aménagée dans ladite zone de positionnement et en ce que le dispositif de refroidissement comprend au moins un insert configuré pour être disposé dans l'ouverture et être interposé entre la paroi de fermeture et le module de puissance.

Le dispositif de charge embarqué selon l'invention, apte à équiper un véhicule automobile électrique, a notamment pour fonction de permettre la transformation d'un courant alternatif fourni par une borne de recharge domestique en un courant continu exploitable par les composants électriques du véhicule électrique, et notamment les composants d'entraînement du véhicule électrique. Ce dispositif de charge embarqué est ici caractérisé par la présence d'un circuit de refroidissement associé au refroidissement d'un module de puissance, avec le circuit de refroidissement qui comporte un insert formant un moyen d'amélioration de l'échange thermique entre le liquide de refroidissement, susceptible de circuler dans le circuit de refroidissement, et le module de puissance.

La paroi de fermeture et le réceptacle sont rendus solidaires pour former le circuit de liquide de refroidissement, le réceptacle étant embouti pour former les méandres d'un canal de circulation que la paroi de fermeture est destinée à sceller pour assurer l'étanchéité de la circulation de liquide de refroidissement.

La paroi de fermeture et le réceptacle peuvent notamment être rendus solidaires en étant soudés par friction malaxage. Cette méthode d'assemblage, assimilable à de la soudure, rend les deux pièces solidaires l'une de l'autre de façon définitive et permet d'éviter les fuites de liquide de refroidissement.

Le réceptacle et la paroi de fermeture peuvent être réalisés dans un même matériau, ce qui permet notamment de faciliter le soudage par friction malaxage.

Dans les zones de positionnement du module de puissance, l'étanchéité est faite par la présence de l'insert qui vient fermer le circuit de refroidissement en recouvrant l'ouverture ménagée intentionnellement dans la paroi de fermeture.

Le module de puissance est un composant électronique comportant en son sein une pluralité de puces et donc susceptible de dégager une forte chaleur lors de son fonctionnement. Selon l'invention, on prévoit d'interposer un insert entre la paroi de fermeture qui participe à délimiter le circuit de refroidissement et le module de puissance pour optimiser l'échange de la chaleur entre ce module de puissance et le liquide de refroidissement circulant dans le circuit.

Plus particulièrement, l'insert présente une forme similaire à celle de l'ouverture ménagée dans la paroi de fermeture, les dimensions de l'insert et de l'ouverture étant prévues pour permettre une zone de recouvrement périphérique dans laquelle l'insert est rendu solidaire de la paroi de fermeture sur le pourtour de l'ouverture.

La présence d'un insert offre la possibilité d'optimiser les performances d'échanges thermiques de l'insert, puisqu'il est plus simple de configurer l'insert pour lui donner des performances thermiques élevées plutôt que de devoir configurer la paroi de fermeture. Dans ce contexte, il est notamment possible de prévoir un matériau différent, notamment plus conducteur thermiquement, pour la réalisation de l'insert, et il est plus facile de former sur une face de l'insert des pions d'échange thermique qui sont destinés à s'insérer dans le conduit au travers du passage du liquide de refroidissement.

L'insert peut être réalisé dans un matériau tel que du cuivre ou un alliage d'aluminium, la paroi de fermeture est réalisée dans un alliage d'aluminium présentant une conductivité thermique moins grande que celle du matériau choisi pour réaliser l'insert.

Selon une caractéristique optionnelle de l'invention, l'insert comprend au moins un fût de fixation du module de puissance.

Le ou les fûts sont destinés à assurer la fixation d'un module de puissance pour rendre celui-ci solidaire de la paroi de fermeture par l'intermédiaire de l'insert interposé entre cette paroi de fermeture et le module de puissance. Notamment, les fûts peuvent présenter un taraudage permettant la fixation du module de puissance sur l'insert par vissage.

On comprend que la présence de l'insert permet ici de mettre en œuvre facilement la réalisation de fûts de vissage qui sont utilisés pour la fixation du module de puissance par vissage.

Selon une caractéristique optionnelle de l'invention, l'insert comporte une plaque dont l'épaisseur est définie entre deux faces opposées, une première face des deux faces opposées étant tournée vers l'intérieur du circuit de refroidissement et susceptible d'être en contact avec le liquide de refroidissement, une deuxième face des deux faces opposées étant tournée à l'opposé du circuit de refroidissement et au contact du module de puissance, l'insert présentant une portion périphérique, destinée à être en contact sur la première face avec une zone de la paroi de fermeture délimitant l'ouverture, et une portion centrale disposée dans l'ouverture et destinée à être en contact du liquide de refroidissement sur la première face et à être en contact du module de puissance sur la deuxième face.

Selon une caractéristique optionnelle de l'invention, l'insert est rendu solidaire de la paroi de fermeture par soudure par friction malaxage. Dans ce contexte, la matière de l'insert et la matière de la paroi de fermeture doivent présenter des températures de fusions compatibles. C'est au niveau de la portion périphérique de l'insert que la soudure par friction malaxage est réalisée.

Selon une caractéristique optionnelle de l'invention, le ou les fûts s'étendent en saillie de la première face de l'insert, avec une extrémité libre du fût qui est fermée et qui s'étend à distance de ladite première face, chaque fût étant ouvert et débouchant sur la deuxième face de l'insert. De la sorte, le module de puissance peut être plaqué sur la deuxième face de l'insert sans que les fûts n'interfèrent.

Selon une caractéristique optionnelle de l'invention, l'insert comprend des pions disposés sur la première face de l'insert.

Selon une caractéristique optionnelle de l'invention, les pions disposés sur la première face de l'insert sont disposés dans la portion centrale de l'insert.

Les pions permettent de favoriser l'échange de chaleur, en augmentant la surface de contact du liquide de refroidissement avec l'insert. Par ailleurs, la présence des pions en travers de la circulation du liquide de refroidissement a pour effet de créer une zone de turbulence qui améliore l'échange thermique entre l'insert et le liquide de refroidissement. La portion centrale de l'insert est ainsi un secteur d'échange comportant sur la première face de l'insert des pions disposés en travers du circuit de refroidissement et destiné à être au contact du module de puissance sur la deuxième face.

Selon une caractéristique optionnelle de l'invention, l'insert et le module de puissance sont en contact direct l'un avec l'autre. On comprend qu'ici aucune pièce ou couche conductrice intermédiaire n'est placée entre l'insert et le module de puissance. Une surface d'échange est formée au contact d'une paroi du module de puissance et la deuxième face de l'insert.

Selon une caractéristique optionnelle de l'invention, une pâte thermique est placée entre l'insert et le module de puissance.

La pâte thermique permet d'augmenter la conductivité thermique entre l'insert et le module de puissance et permet d'assurer le contact entre le module de puissance et l'insert sans que de l'air ne s'interpose, afin d'éviter que les calories à évacuer du module de puissance ne soit mal transmises à l'insert et que celui-ci ne surchauffe.

Selon une caractéristique optionnelle de l'invention, l'insert comprend au moins un guide configuré pour orienter le flux du liquide de refroidissement sur les pions. L'au moins un guide est formé sur la première face de l'insert, c'est-à-dire la face porteuse des pions et destinée à être en regard du liquide de refroidissement.

L'insert comprend par exemple deux guides formant un canal. Les pions sont disposés entre les guides de sorte à ce que le flux de liquide de refroidissement soit orienté vers les pions de l'insert. Le guidage du flux permet de s'assurer qu'une grande quantité de liquide de refroidissement est en contact avec les pions afin d'échanger de la chaleur avec ceux-ci.

Selon une caractéristique optionnelle de l'invention, l'au moins un guide est réalisé d'un seul tenant avec l'insert.

Selon une caractéristique optionnelle de l'invention, les pions sont réalisés d'un seul tenant avec l'insert.

Selon une caractéristique optionnelle de l'invention, l'insert est réalisé dans un matériau différent de celui de la paroi de fermeture. Notamment, le matériau utilisé pour l'insert peut être choisi pour disposer d'une meilleure conduction thermique que celle du matériau du réceptacle et de la paroi de fermeture.

Lorsque l'insert et la paroi de fermeture sont soudés ensemble, notamment par friction malaxage, il est nécessaire d'utiliser un matériau pour la réalisation de l'insert qui présente une température de fusion similaire à celle du matériau utilisé pour la réalisation de la paroi de fermeture.

Selon une caractéristique optionnelle de l'invention, l'ouverture dans la paroi de fermeture et l'insert sont configurés de sorte qu'un axe d'extension principal de l'insert est sécant à une direction d'écoulement du liquide de refroidissement dans une zone de positionnement du module de puissance.

Plus particulièrement, l'axe d'extension principal de l'insert peut être perpendiculaire à la direction d'écoulement du liquide de refroidissement. On définit l'axe d'extension principal de l'insert comme l'axe associé à la plus grande dimension de l'insert. De manière équivalente, la forme de l'insert étant similaire à la forme de l'ouverture qu'elle doit recouvrir, on peut définir une forme allongée de l'ouverture avec un axe d'allongement principal de l'ouverture, l'ouverture étant orientée selon cet aspect de l'invention de sorte que l'axe d'allongement principal est sécant, le cas échéant perpendiculaire, à la direction d'écoulement du liquide de refroidissement.

Selon une caractéristique optionnelle de l'invention, l'insert comprend deux fûts disposés de part et d'autre de la portion centrale de l'insert, l'axe d'extension principal de l'insert étant défini par une droite passant par les deux fûts.

Tel qu'évoqué ci-dessus, les fûts sont destinés à assurer la fixation d'un module de puissance pour rendre celui-ci solidaire de la paroi de fermeture par l'intermédiaire de l'insert interposé entre cette paroi de fermeture et le module de puissance. Notamment, les fûts peuvent présenter un taraudage permettant la fixation de l'insert par vissage. Les fûts peuvent être disposés à deux extrémités opposées de l'insert. L'axe d'extension principal de l'insert peut notamment être défini par une droite coupant l'axe de révolution de chacun des deux fûts de l'insert.

Cet agencement présente l'avantage de disposer les fûts, lorsque l'insert est positionné sur l'ouverture, dans des portions latérales du circuit de liquide de refroidissement, de sorte que ces fûts nécessaires à la fixation du module de puissance par rapport à la paroi de fermeture ne forment pas d'obstacle à l'écoulement du liquide de refroidissement qui peut ainsi circuler librement dans une zone d'échange formée au niveau d'une portion centrale de l'insert. Or, c'est au droit de cette portion centrale de l'insert que sont disposées les puces électroniques présentes dans le module de puissance et il importe que les conditions d'écoulement du liquide de refroidissement dans cette zone soient optimales.

Cet agencement particulier d'un élément du dispositif de charge embarqué en travers d'une direction de circulation du liquide de refroidissement, ici défini par l'orientation de l'insert, peut être définie de manière équivalente par l'orientation du module de puissance, que ce soit par l'orientation des puces électroniques présentes dans le module de puissance ou par l'orientation des broches de connexion électriques de ce module de puissance.

Selon une caractéristique optionnelle de l'invention, le module de puissance comporte un boîtier au sein duquel sont disposées côte à côte des puces électroniques, et en saillie duquel s'étendent des broches de connexion électriques, connectées aux puces à l'intérieur du boîtier et destinées à être liées à une carte de circuits imprimés du dispositif de charge embarqué, l'agencement desdites broches de connexion électriques les unes par rapport aux autres sur au moins un bord du boîtier et/ou l'agencement des puces électroniques les unes par rapport aux autres définissant un axe d'allongement principal du module de puissance, le module de puissance étant disposé dans sa zone de positionnement de manière à ce que l'axe d'allongement principal du module de puissance soit sécant à la direction d'écoulement du circuit de liquide de refroidissement dans ladite zone de positionnement du module de puissance.

Plus particulièrement, l'axe d'allongement principal du module de puissance peut être perpendiculaire à la direction d'écoulement du circuit de liquide de refroidissement.

Une première définition de l'axe d'allongement principal peut être fonction de l'agencement des broches de connexion électriques. Notamment, lesdites broches de connexion électriques s'étendent sur au moins un bord du boîtier du module de puissance en étant alignés le long de l'axe d'allongement principal du module de puissance. Le module de puissance présente notamment une forme rectangulaire et le ou les bords du module de puissance comprenant les broches électriques sont les grands côtés de cette forme rectangulaire.

Une deuxième définition de l'axe d'allongement principal peut être fonction de l'agencement des puces électroniques. Notamment, les puces électroniques peuvent être disposées au sein du module de puissance en au moins une rangée selon un alignement définissant l'axe d'allongement principal du module de puissance.

Cet agencement présente l'avantage de pouvoir refroidir de manière uniforme les puces électroniques présentes dans le module de puissance. En considérant le sens de circulation du liquide de refroidissement dans la zone de positionnement du module de puissance, le liquide arrivant dans la zone de positionnement se retrouve simultanément en regard de chacune des puces de la rangée et donc est apte à récupérer des calories de chacune des puces de manière homogène.

D'autres caractéristiques et avantages de l'invention apparaîtront encore au travers de la description qui suit d'une part, et de plusieurs exemples de réalisation donnés à titre indicatif et non limitatif en référence aux dessins schématiques annexés d'autre part, sur lesquels :
[fig 1] est une représentation schématique partielle d'un dispositif de charge embarqué de véhicule automobile, rendant notamment visible un carter, un module de puissance et un dispositif de refroidissement associé ;
[fig 2] est une représentation schématique vue du dessus d'une zone de positionnement d'un module de puissance, ledit module de puissance étant fixé sur le dispositif de refroidissement avec un insert interposé, un boîtier du module de puissance étant représenté en transparent pour rendre visible un alignement de puces électroniques au sein du module de puissance ; et
[fig 3] est une vue en coupe de la zone de positionnement illustrée sur la figure 2, rendant plus particulièrement visible l'interposition de l'insert entre une paroi de fermeture du dispositif de refroidissement et le module de puissance ;
[fig 4] est une représentation schématique de l'insert ; et
[fig 5] est une représentation schématique d'une variante de réalisation de l'insert.

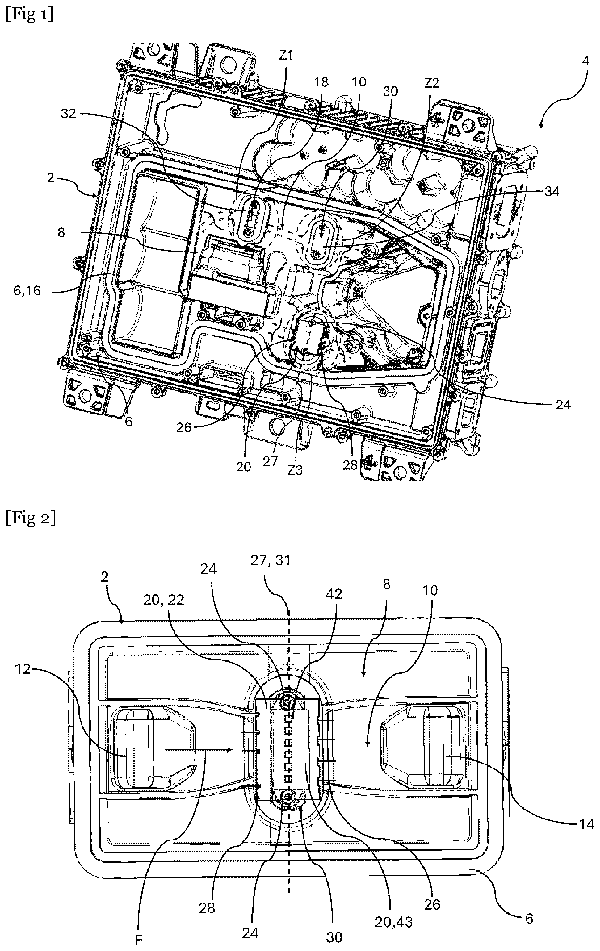

La figure 1 est représentative d'un carter 2 de dispositif de charge embarqué 4. Le carter 2 est dimensionné pour recevoir une pluralité de composants électroniques parmi lesquels on peut trouver des bobines, des transistors ou encore, sans que cela soit limitatif, au moins une carte de circuits imprimés, et parmi lesquels on a notamment un ou plusieurs modules de puissance 20. Tous ces composants sont disposés dans un volume interne défini par le carter 2 et un couvercle ici non représenté pour rendre visible l'intérieur du carter.

Le carter 2 est équipé d'un dispositif de refroidissement par circulation de liquide de refroidissement, notamment destiné à la gestion thermique des modules de puissance, particulièrement aptes à s'échauffer lors de leur fonctionnement.

Le dispositif de refroidissement comporte un réceptacle 6 et une paroi de fermeture 8, qui définissent entre eux un circuit 10 de fluide refroidissement. Le réceptacle 6 du carter 2 comprend une portion plane 16 décrivant un pourtour du circuit 10 de liquide de refroidissement. Le réceptacle est une pièce emboutie disposée dans le carter et configurée pour former des méandres d'un canal de circulation de fluide de refroidissement. La paroi de fermeture 8 est configurée pour sceller le circuit 10 de liquide de refroidissement du réceptacle 6 en venant reposer contre la portion plane 16 du réceptacle 6.

La paroi de fermeture 8 et le réceptacle 6 sont ici soudés par friction malaxage. Cette méthode de soudure est simple à mettre en œuvre et permet de limiter les risques de fuite du circuit 10 de refroidissement. Dans ce contexte, il est avantageux que le matériau du réceptacle 6 soit le même que celui de la paroi de fermeture 8.

Le circuit 10 de refroidissement est particulièrement prévu pour refroidir le ou les modules de puissance 20, et chaque module de puissance 20 est ainsi positionné contre une paroi de ce circuit de refroidissement, en étant rendu solidaire de la paroi de fermeture, par l'intermédiaire d'un insert selon l'invention tel que cela va être décrit ci-après.

Chaque module de puissance 20 est rendu solidaire de la paroi de fermeture dans une zone de positionnement qui lui est propre. Dans le dispositif de charge embarqué illustré ici, trois modules de puissance sont prévus, un seul étant représenté sur la figure 1. Plus particulièrement, cette figure 1 illustre trois zones de positionnement dont la configuration a été rendue différente les unes des autres à dessein, pour rendre plus visible la coopération de la paroi de fermeture 8, de l'insert et du module de puissance.

La paroi de fermeture 8 comprend des ouvertures 18 respectivement disposées au droit d'une portion du circuit 10 de liquide de refroidissement, chaque ouverture 18 définissant une zone de positionnement d'un module de puissance. La figure 1 rend visible une de ces ouvertures 18 dans une première zone de positionnement Z1 d'un module de puissance dans laquelle ni l'insert, ni le module de puissance n'ont été illustré pour ne pas masquer l'ouverture. Les ouvertures 18 de la paroi de fermeture 8 présentent ici une forme oblongue. Il est notable que ces ouvertures sont orientées de telle sorte que la grande dimension de la forme oblongue est sécante, ici perpendiculaire, à la direction d'écoulement du liquide de refroidissement au sein du circuit 10 au niveau de la zone de positionnement correspondante.

Des inserts 30 sont rapportés contre la paroi de fermeture 8, pour venir en recouvrement des ouvertures 18 et assurer la fermeture du circuit de liquide de refroidissement dans la zone de positionnement de module de puissance correspondante. Chaque insert 30 est destiné à être interposé entre la paroi de fermeture 8 et un module de puissance, dans une des zones de positionnement. La figure 1 permet de rendre visible, dans une deuxième zone de positionnement Z2, l'un de ces inserts 30, le module de puissance 20 associé étant ici retiré. L'insert 30 présente une forme allongée, ici oblongue. L'insert 30 est dimensionné pour recouvrir intégralement l'ouverture 18 de la paroi de fermeture 8 à laquelle l'insert est associé.

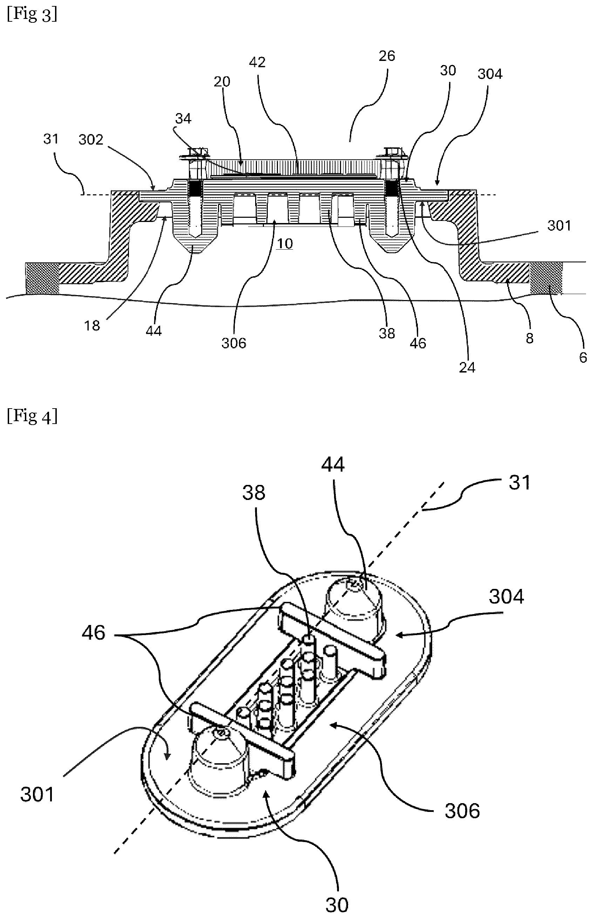

Selon un aspect de l'invention, l'insert 30 est positionné dans l'ouverture 18 de sorte à se retrouver orienté en travers, sensiblement perpendiculairement à la direction d'écoulement du liquide de refroidissement dans la zone de positionnement qui est associée à cet insert 30. Cette orientation de l'insert peut notamment être définie par l'orientation d'un axe d'extension principal 31 de l'insert, qui correspond à la plus grande dimension de l'insert, et qui correspond ici à une droite passant par deux fûts de fixation formés sur l'insert et présentés plus en détail figure 3.

L'insert 30 comprend une portion périphérique configurée pour être en contact avec une zone périphérique 32 plane de la paroi de fermeture 8, cette zone périphérique délimitant l'ouverture 18. Un tel positionnement de l'insert 30 sur une paroi plane autour de l'ouverture 18 permet de solidariser par soudure par friction malaxage l'insert 30 et la paroi de fermeture 8. L'insert présente une première face, ici non visible, qui est tournée vers l'intérieur du circuit 10 de liquide de refroidissement, cette première face étant destinée à être en contact avec le liquide de refroidissement. L'insert 30 présente une deuxième face 302 opposée, notamment visible sur la figure 1 pour l'insert présent dans la deuxième zone de positionnement Z2 et non encore recouvert par un module de puissance, et c'est cette deuxième face 302 qui est destinée à être en contact du module de puissance 20.

La paroi de fermeture 8 comprend ici une troisième zone de positionnement Z3 dans laquelle est cette fois représenté un module de puissance 20. On comprend que le module de puissance 20 est ici monté sur un insert 30 semblable à ce qui vient d'être décrit, et que le module de puissance 20 est fixé au sein du dispositif de charge embarqué de telle sorte qu'une de ses parois est en contact avec l'insert 30. Une surface d'échange 34 est ainsi définie dans la zone de contact de l'insert 30 avec le module de puissance, et cette surface d'échange 34 forme un couloir thermique apte à transmettre les calories dégagées par le fonctionnement du module de puissance 20 vers le liquide de refroidissement s'écoulant contre l'insert 30.

De la sorte, dans la zone de positionnement, la surface d'échange 34 formant interface entre le liquide de refroidissement et le module de puissance 20 n'est pas réalisée directement sur la paroi de fermeture 8 mais sur un insert 30 rapporté dans un deuxième temps sur la paroi de fermeture, avant le montage de l'insert. Ceci est avantageux dans la mesure où cela permet de prévoir une paroi de fermeture standard, sans se soucier que cette interface présente des propriétés de conductivité thermique optimales, et d'optimiser les propriétés de conductivité thermique seulement sur l'insert, plus facile à modifier du fait de sa taille. Tel que cela sera décrit plus en détails en référence aux figures 3 et 4 notamment, il est dans ce contexte plus facile de réaliser des pions d'échange thermique destinés à être inséré dans le circuit de liquide de refroidissement pour augmenter la surface d'échange, de prévoir des moyens de guidage du liquide de refroidissement au droit de la surface d'échange, et il est également plus facile et moins coûteux de s'assurer que la surface d'échange soit réalisée avec un matériau dont les propriétés de conductivité thermique sont optimales. On comprend qu'il est avantageux que l'insert 30 soit réalisé dans un matériau présentant une conductivité thermique supérieure au matériau utilisé pour la réalisation de la paroi de fermeture.

Le module de puissance 20 présente une forme rectangulaire, avec un boîtier 22 logeant des puces électroniques et duquel sortent des broches de connexion électrique 26 pour permettre le raccordement électrique des puces électroniques à un composant électronique comme une carte de circuits imprimés ici non représentée. Une première paroi du boîtier est destinée à être plaquée contre l'insert 30 comme précédemment évoqué. Les broches de connexion électrique 26 s'étendent le long des deux grands bords 28 du boîtier du module de puissance 20, ces deux grands bords 28 prolongeant perpendiculairement la première paroi du boîtier plaquée contre l'insert.

Un axe d'allongement principal 27 du module de puissance 20, permettant de définir l'orientation de ce dernier par rapport au dispositif de refroidissement et à l'insert 30, est défini comme étant un axe parallèle aux deux grands bords 28 du module de puissance. Le module de puissance 20 est orienté au sein du dispositif de charge embarqué de telle sorte qu'il soit placé transversalement, et plus particulièrement ici perpendiculairement, à la direction d'écoulement du liquide de refroidissement au niveau de la zone de positionnement correspondant audit module de puissance.

Il convient de noter que l'on peut également définir l'orientation du module de puissance en considérant l'alignement des broches de connexion électrique 26 le long d'un bord du boîtier du module de puissance, puisque cet alignement est parallèle à l'axe d'allongement principal, ou encore en considérant l'alignement de deux encoches de fixation 24 disposées respectivement à l'une des extrémités du module de puissance 20 et permettant la fixation par vissage du module de puissance sur l'insert et/ou sur la paroi de fermeture 8

Une pâte thermique peut être placée sur la surface d'échange 34 entre l'insert 30 et le module de puissance 20. La pâte thermique a notamment pour fonction de s'assurer que l'insert 30 et le module de puissance sont au contact l'un de l'autre sans poche d'air emprisonné entre eux et elle est ainsi configurée pour améliorer la conductivité thermique de la surface d'échange 34 entre l'insert 30 et le module de puissance 20.

La figure 2 est une représentation schématique d'une portion du circuit 10 au niveau d'une zone de positionnement, la portion de circuit étant ainsi équipée d'un module de puissance 20 fixé sur un insert 30. Dans la représentation schématique de la figure 2, le sens d'écoulement du liquide de refroidissement est défini selon une direction représentée par la flèche F, le liquide de refroidissement s'écoulant depuis une entrée 12 jusqu'à une sortie 14, entre le réceptacle 6 et la paroi de fermeture ici représentée en transparence pour rendre visible la forme du canal défini par le réceptacle.

Le module de puissance est représenté partiellement en transparence, notamment pour rendre compte de l'orientation de puces électroniques dans l'agencement spécifique du module de puissance par rapport à la direction d'écoulement de liquide de refroidissement.

Le module de puissance 20 comporte ainsi un boîtier 22 ici représenté en transparence, pour rendre visible des puces électroniques 42 disposées sur un support 43 duquel s'étendent les broches de connexion électriques 26 précédemment évoquées. Les puces électroniques 42 sont disposées sur le support 43 de telle sorte qu'elles peuvent participer à définir une orientation du module de puissance. Plus particulièrement, les puces électroniques 42 sont agencées selon un axe d'alignement qui est parallèle à l'axe d'allongement principal 27 du module de puissance 20 précédemment évoqué. L'orientation du module de puissance 20, transversale et perpendiculaire le cas échéant, par rapport à la direction d'écoulement du liquide de refroidissement peut ainsi être définie par l'alignement des broches 26 le long d'un bord 28 du boîtier du module de puissance, mais également et avantageusement par l'alignement des puces électroniques. Dans l'exemple illustré, les puces électroniques 42 sont dites alignées selon un axe d'alignement dans la mesure où elles forment une rangée droite, parallèle à cet axe d'alignement.

Le liquide de refroidissement circulant dans le dispositif de refroidissement est ainsi apte à circuler au droit des puces électroniques en passant sensiblement simultanément au droit de chacune de ces puces. Le liquide de refroidissement présente ainsi une température similaire au contact de chacune des puces électroniques 42 du module de puissance 20 et le refroidissement de ces puces via l'échange thermique par l'insert est homogène. Les puces 42 ne présentent ainsi pas d'écart de température et la gestion thermique du module de puissance est simplifiée.

La vue en coupe de la figure 3, réalisée dans un plan de coupe perpendiculaire à la direction d'écoulement du liquide de refroidissement, rend visible cet alignement des puces électroniques parallèlement à l'axe d'allongement principal 27. Par ailleurs, cette figure 3 rend plus particulièrement visible la caractéristique de l'invention selon laquelle l'insert 30 est interposé entre la paroi de fermeture 8 et le module de puissance 20.

L'insert 30 comporte une portion périphérique 304 qui est dimensionnée pour venir se placer dans la zone périphérique 32 précédemment évoquée et formée dans la paroi de fermeture 8, autour de l'ouverture 18. L'insert 30 comporte par ailleurs une portion centrale 306 destinée à être disposée au droit de l'ouverture et à recouvrir celle-ci. L'insert présente par ailleurs une première face 301 tournée vers le circuit de liquide de refroidissement, cette première face 301 étant représentée sur la figure 4, et une deuxième face 302 tournée vers l'extérieur du dispositif de refroidissement, cette deuxième face 302 étant visible dans la deuxième zone de positionnement Z2 sur la figure 1.

La portion centrale 306 est ainsi destinée, sur la première face de l'insert, à être au contact du liquide de refroidissement, et sur la deuxième face de l'insert, à former la surface d'échange 34 au contact du module de puissance 20. La portion centrale 306 est lisse sur la deuxième face pour permettre ce contact avec le module de puissance, et elle peut le cas échéant être recouvert de pâte thermique. La portion centrale 306 présente sur la première face de l'insert des pions et des guides, configurés pour une interaction optimale avec le liquide de refroidissement, ainsi que des fûts de fixation 44, qui s'étendent dans le volume défini entre la paroi de fermeture 8 et le réceptacle 6, et qui ont pour fonction de coopérer avec des vis de fixation du module de puissance.

La figure 4 illustre en perspective l'insert de la figure 3, en vue de dessous pour rendre visible la première face 301 et les différents moyens portés par la portion centrale de l'insert 30 sur cette première face 301.

L'insert 30 présente ainsi une forme de plaque dont font saillie une pluralité de moyens destinés ici aussi bien à la fonction d'échange thermique qu'à la fonction de fixation du module de puissance. L'insert 30 comprend notamment des pions 38 qui s'étendent en saillie, perpendiculairement ou sensiblement perpendiculairement à la première face 301 de l'insert 30. Les pions 38 sont destinés à s'étendre au travers du flux de liquide de refroidissement. Les pions 38 augmentent la surface de contact entre le liquide de refroidissement et les inserts 30. Plus il y a de pions 38 sur l'insert 30, meilleur est l'échange de calories entre l'insert 30 et le liquide de refroidissement. Les pions 38 permettent aussi de créer une turbulence du liquide de refroidissement ce qui favorise un transfert thermique plus efficace.

L'insert 30 comprend tel qu'évoqué deux fûts 44 dans lequel s'étend un taraudage pour coopérer avec les vis traversant les deux encoches 24 de fixations du module de puissance 20. Les fûts 44 s'étendent en saillie de la première face 301 de l'insert 30, de manière à s'étendre dans le circuit de liquide de refroidissement. Les fûts sont ici uniquement du côté de la deuxième face de l'insert.

On distingue sur la figure 4 un secteur de fixation de l'insert, formé par la présence des fûts 44, et un secteur d'échange de l'insert 30, formé par la présence des pions 38, le secteur de fixation de l'insert s'étendant autour du secteur d'échange de l'insert 30. L'orientation spécifique de l'insert telle qu'elle a été précédemment évoquée, à savoir une orientation sécante et le cas échéant perpendiculaire à l'axe d'extension principal de l'insert par rapport à la direction d'écoulement du liquide de refroidissement dans la zone de positionnement correspondante, permet de disposer le secteur de fixation de l'insert de telle sorte que les fûts 44 sont disposés dans le circuit sur les côtés du flux de liquide de refroidissement. En d'autres termes, les fûts 44 ne faisant pas partie d'une zone d'échange du fait de l'orientation perpendiculaire du module de puissance 20 et de l'insert 30, l'écoulement du liquide de refroidissement sur les pions 38 n'est pas perturbé au préalable par la présence d'un fût 44 de l'insert 30.

Entre les fûts de fixation et les pions, l'insert 30 comprend deux guides 46, réalisés respectivement sous forme d'un muret formant saillie de la première face de l'insert et orienté dans la direction d'écoulement du liquide de refroidissement, c'est-à-dire perpendiculairement à l'axe d'extension principal de l'insert. Ces guides 46 sont configurés pour orienter l'écoulement du liquide de refroidissement vers les pions 38, de façon à éviter que le liquide de refroidissement s'échappe sur les côtés du pions 38, dans une zone non pourvue de pions 38. Les deux guides 46 permettent d'améliorer la dissipation thermique puisque d'une part on s'assure que le liquide de refroidissement entre en contact avec les pions et puisque d'autre part, en centrant le liquide de refroidissement, on augmente sa vélocité en réduisant sa section de passage.

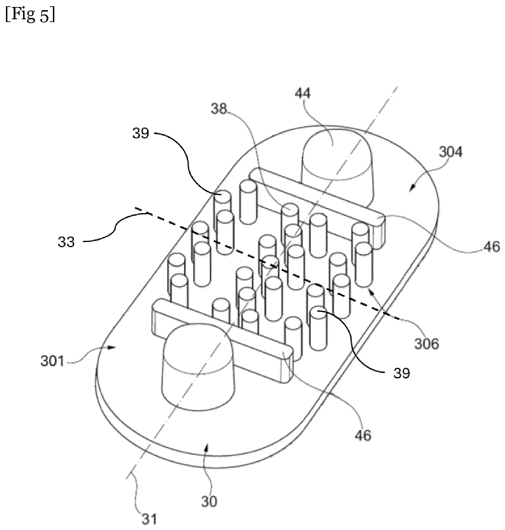

La figure 5 est une représentation schématique d'une variante de réalisation de l'insert 30, qui diffère de ce qui a été précédemment décrit et illustré par le nombre et l'agencement des pions sur la première face 301. Dans cette variante, l'insert 30 comprend des pions 38 disposés au centre de la portion centrale 306, de la même manière que l'insert représenté sur la figure 4, et il comporte en outre des pions additionnels 39, pour augmenter la surface d'échange entre l'insert 30 et le liquide de refroidissement.

Dans cette variante, on distingue les pions 38 et les pions additionnels 39, tous disposés sur la première face 301, dans la mesure où les pions 38 s'étendent dans une bande centrale, le long de l'axe d'extension principal 31, qui englobe les fûts de fixation 44 et où les pions additionnels 39 sont disposés de part et d'autre des pions 38 selon un axe d'extension transversal, 33, perpendiculaire à l'axe d'extension principal 31, et qui illustre la petite dimension de l'insert. On augmente ainsi le nombre d'éléments susceptibles compris entre les deux guides 46 dans la portion centrale 306 de l'insert 30 et donc susceptibles d'être au contact du passage de fluide sans que celui-ci soit dévié par les fûts de fixation 44.

L'invention, telle qu'elle vient d'être décrite, atteint bien le but qu'elle s'était fixée, et permet de proposer un dispositif de charge embarqué aux performances thermiques optimisées. Des variantes non décrites ici pourraient être mises en œuvre sans sortir du contexte de l'invention, dès lors que, conformément à l'invention, elles comprennent un insert susceptible d'améliorer la capacité de refroidissement d'un module de puissance conformément à l'invention.

## Revendications

1. Dispositif, en particulier un dispositif de charge embarqué pour véhicule électrique, comprenant au moins un carter (2), des composants électroniques logés dans ledit carter et parmi lesquels au moins un module de puissance (20), le carter logeant en outre un dispositif de refroidissement de l'au moins un module de puissance, le dispositif de refroidissement comportant un réceptacle (6) qui comprend au moins un canal de liquide de refroidissement et une paroi de fermeture (8) configurée pour reposer contre le réceptacle (6) pour former avec ledit canal un circuit (10) de liquide de refroidissement, ledit module de puissance (20) étant rendu solidaire de la paroi de fermeture (8) dans une zone de positionnement (Z1, Z2, Z3) du module de puissance, le dispositif de refroidissement étant **caractérisé en ce que** la paroi de fermeture (8) comprend au moins une ouverture (18) aménagée dans ladite zone de positionnement et **en ce que** le dispositif de refroidissement comprend au moins un insert (30) configuré pour être disposé dans l'ouverture (18) et être interposé entre la paroi de fermeture et le module de puissance.

2. Dispositif selon la revendication 1, dans lequel l'insert (30) comprend au moins un fût (44) de fixation du module de puissance (20).

3. Dispositif selon la revendication 1 ou 2, dans lequel l'insert (30) comporte une plaque dont l'épaisseur est définie entre deux faces opposées, une première face (301) des deux faces opposées étant tournée vers l'intérieur du circuit (10) de refroidissement et susceptible d'être en contact avec le liquide de refroidissement, une deuxième face (302) des deux faces opposées étant tournée à l'opposé du circuit (10) de refroidissement et au contact du module de puissance (20), l'insert (30) présentant une portion périphérique (304), destinée à être en contact sur la première face (301) avec une zone (32) de la paroi de fermeture (8) délimitant l'ouverture (18), et une portion centrale (306) disposée dans l'ouverture (18) et destinée à être en contact du liquide de refroidissement sur la première face (301) et à être en contact du module de puissance (20) sur la deuxième face (302).

4. Dispositif selon les revendications 2 et 3, dans lequel le ou les fûts (44) s'étendent en saillie de la première face (301) de l'insert (30), avec une extrémité libre du fût (44) qui est fermée et qui s'étend à distance de ladite première face (301), chaque fût (44) étant ouvert et débouchant sur la deuxième face (302) de l'insert (30).

5. Dispositif selon l'une des revendications 3 ou 4, dans lequel l'insert (30) comprend des pions (38) disposés sur la première face (301) de l'insert (30).

6. Dispositif selon la revendication, dans lequel l'insert (30) comprend au moins un guide (46) configuré pour orienter le flux du liquide de refroidissement sur les pions (38).

7. Dispositif selon l'une des revendications 5 ou 6, dans lequel l'au moins un guide et/ou les pions sont réalisés d'un seul tenant avec l'insert.

8. Dispositif selon l'une des revendications 1 à 7, dans lequel l'insert (30) est dans un matériau différent de celui de la paroi de fermeture (8).

9. Dispositif selon l'une des revendications 1 à 8, dans lequel l'ouverture (18) dans la paroi de fermeture (8) et l'insert (30) sont configurés de sorte qu'un axe d'extension principal de l'insert (30) est sécant à une direction d'écoulement du liquide de refroidissement dans une zone de positionnement (Z1, Z2, Z3) du module de puissance (20).

10. Dispositif selon l'une des revendications 1 à 9, dans lequel le module de puissance (20) comporte un boîtier au sein duquel sont disposées côte à côte des puces électroniques (42), et en saillie duquel s'étendent des broches de connexion électriques (26), connectées aux puces à l'intérieur du boîtier et destinées à être liées à une carte de circuits imprimés du dispositif, l'agencement desdites broches de connexion électriques (26) les unes par rapport aux autres sur au moins un bord du boîtier et/ou l'agencement des puces électroniques (42) les unes par rapport aux autres définissant un axe d'allongement principal (27) du module de puissance, le module de puissance (20) étant disposé dans sa zone de positionnement (Z1, Z2, Z3) de manière à ce que l'axe d'allongement principal (27) du module de puissance soit sécant à la direction d'écoulement du circuit de liquide de refroidissement dans ladite zone de positionnement du module de puissance.
